# EUROPEAN PATENT SPECIFICATION

(11) **EP 2 221 864 B1**
(45) Date of publication and mention of the grant of the patent: **11.04.2018**
(21) Application number: 10163473.1
(22) Date of filing: 04.12.2006
(51) Int. Cl.: H01L 21/768, H01L 23/532

(54) **Method for forming Cu film**
Verfahren zur Herstellung eines Kupferfilms
Procédé de formation d'un film en cuivre

(30) Priority: 02.12.2005 JP 2005348856
(43) Date of publication of application: 25.08.2010
(62) Divisional of application: 06833944.9
(73) Proprietor: Ulvac, Inc., Chigasaki-shi, Kanagawa 253-8543 (JP)
(72) Inventor: Yoshihama, Tomoyuki, Susuono-shi Shizuoka 410-1231 (JP); Harada, Masamichi, Susono-shi Shizuoka 410-1231 (JP); Toyoda, Satoru, Susono-shi Shizuoka 410-1231 (JP); Ushikawa, Harunori, Susono-shi Shizuoka 410-1231 (JP)
(74) Representative: Epping - Hermann - Fischer

(56) References cited:
- US-A- 5 909 637
- US-A- 5 918 150
- US-A1- 2002 006 468
- US-A1- 2002 134 686
- US-A1- 2004 219 369
- US-B1- 6 569 756
- GANDIKOTA S ET AL: "Adhesion studies of CVD copper metallization" MICROELECTRONIC ENGINEERING, ELSEVIER PUBLISHERS BV., AMSTERDAM, NL LNKD- DOI:10.1016/S0167-9317(99)00326-3, vol. 50, no. 1-4, 1 January 2000 (2000-01-01), pages 547-553, XP004237713 ISSN: 0167-9317

## Description

### Technical Field

The present invention relates to a method of forming a Cu film, and more particularly to a method of forming a Cu film in which the adhesiveness between a barrier metal film and a Cu film is improved by processing in particular the interface between the barrier metal film and the Cu film.

### Background Art

Conventionally, the formation of a Cu film is performed by forming a trench and/or a via hole in an insulation film (for example, silicon oxide film) formed on a substrate, next forming a barrier metal film (film of TiN, TaN, WN and the like) for preventing diffusion of Cu in the insulation film by a sputtering method or a CVD method, and then forming the Cu film by the CVD method, whereby a Cu wiring film is formed.

When the Cu film is formed by the CVD method as described above, the Cu film is directly formed on the barrier metal film by the CVD method, the Cu film is formed by the CVD method on a titanium nitride film or a tantalum nitride film after these films are formed on a barrier metal film by the CVD method using an organic titanium material or an organic tantalum material (refer to, for example, Patent Document 1), or the Cu film is formed on a thin Cu film by the CVD method after the thin Cu film is formed on a barrier metal film by a sputtering method (refer to, for example, Patent Document 2).

In the above conventional art, the adhesiveness between the barrier metal film and the Cu film is not necessarily satisfactory, from which a problem arises in that these films cannot withstand a CMP process and the like performed thereafter.

When the Cu film is directly formed on the barrier metal film as described above, the adhesiveness between the barrier metal film and the Cu film is bad. In particular, the adhesiveness of a Ta barrier metal film is not improved even if it is subjected to a heat treatment (anneal processing) after it is formed. In addition, the initial nucleus creation density of Cu is small on the barrier metal film, and thus it is difficult to obtain a smooth plane surface.

Further, when the Cu film is simply formed by the CVD method after the titanium nitride or the tantalum nitride is formed on the barrier metal film by the CVD method as disclosed in Patent Document 1, satisfactory adhesiveness cannot always be obtained.

Further, when the Cu film is formed by the CVD method after the thin Cu film is formed on the barrier metal film by the sputtering method as disclosed in Patent Document 2, a problem also arises in that the adhesiveness is not necessarily improved thereby. That is, since the thickness of the Cu film formed by the sputtering method depends on the geometrical shape of a substrate surface on which the Cu film is formed, when the width and the like of a trench are narrow, the Cu film is insufficiently formed in the side portion and the bottom portion of a deep groove and the like, from which a problem arises in that not only a uniform film thickness, which is effective to improve the adhesiveness, cannot be obtained but also a film thickness is increased in a field portion other than the groove and the like. When the Cu film is thick, the nucleation is selectively performed in the field portion at the time of forming the Cu film by the CVD method, resulting in a cause for poor step coverage at the side surface portion or the bottom surface portion. US 2004/0219369 discloses numerous methods of improving the adhesion between a barrier layer (inter alia Ta or Ti) and a CVD Cu film. One method involves exposing a reactive barrier surface to an adhesion promoting agent such as, inter alia, a nitrogen-containing compound.
[Patent Document 1] Japanese Patent Application Laid-Open Publication No. 2004-40128 (claims and the like)
[Patent Document 2] Japanese Patent Application Laid-Open Publication No. 4-242937 (claims and the like)

### Disclosure of the Invention

### Problems to be Solved by the Invention

An object of the present invention is to solve the problems of the conventional art described above and to provide a method of forming a Cu film capable of improving the adhesiveness between a barrier metal film and a Cu film.

### Means for Solving the Problems

The inventors have completed the present invention by finding that the problem that the adhesiveness between a barrier metal film of Ti, Ta and the like formed by a sputtering method (hereinafter, also referred to as PVD-Ti film in case of the Ti film) and a Cu film formed by a CVD method (hereinafter, also referred to as CVD-Cu film) is deteriorated can be solved by performing an appropriate post-processing after the barrier metal film is formed or by performing a post anneal processing at an appropriate temperature.

In this case, when the barrier metal film is caused to chemically absorb gas containing nitrogen atoms (for example N₂ gas) on the surface thereof as the post-processing after the barrier metal film is formed, the adhesiveness can be secured by an anneal processing performed at a low temperature (400°C or less). More specifically, it is considered that since the chemically absorbed nitrogen molecular layer occupies an active metal adsorption site, the formation of a reaction product layer created by the reaction with impurities such as oxygen, fluorine compounds, water, ammonia and the like on the surface of the barrier metal film (for example, when the impurities is oxygen, an interface layer of titanium oxide and the like resulting from the reaction with titanium) is suppressed, and thus mutual diffusion can be easily performed between the barrier metal (Ti, Ta, and the like) and Cu even if the anneal processing is performed at a low temperature, that is, the adhesiveness can be improved.

When the annealing is performed within the above temperature range, no stress migration of Cu is caused in the formed films and durability can be improved. When an anneal processing temperature is less than 100°C, the adhesiveness of the interface between it and the CVD-Cu film is not good, and when the anneal processing temperature exceed 400°C, metal is expanded during the process and there is a possibility that the Cu film may be broken.

Further, in a method of forming a Cu film of the present invention by forming a Ti film or a Ta film as a barrier metal film on a substrate by a sputtering method and forming the Cu film on the barrier metal film by a CVD method, the method comprises that after a molecular layer containing nitrogen atoms is formed on the barrier metal film by causing the barrier metal layer to absorb gas containing nitrogen atoms on the surface thereof and the Cu film is formed on the molecular layer containing nitrogen atoms by the CVD method, an anneal processing is performed at 100 to 400°C and preferably at 200 to 350°C. After the anneal processing is performed, a Cu film is further formed on the Cu film by a PVD method or an ALD method. Then, when desired, the anneal processing is performed again at 100 to 400°C and preferably at 200 to 350°C. The temperature range of the anneal processing is also selected based on the ground described above. The barrier metal film is formed by supplying Ar gas also in this forming method.

Further, in a method of forming a Cu film of the present invention by forming a Ti film or a Ta film as a barrier metal film by a sputtering method and forming the Cu film on the barrier metal film by a CVD method, the method comprises that after a molecular layer containing nitrogen atoms is formed on the barrier metal film by causing the barrier metal layer to absorb gas containing nitrogen atoms on the surface thereof and the Cu film is formed on the nitrogen molecular layer by the CVD method, a Cu film is further formed on the Cu film by a PVD method, a plating method, the CVD method, or an ALD method, and then an anneal processing is performed at 100 to 400°C and preferably at 200 to 350°C. The temperature range of the anneal processing is also selected based on the ground described above. The barrier metal film is formed by supplying Ar gas also in this forming method.

As the gas containing the nitrogen atoms, N₂ gas and NH₃ gas can be picked up. Further, as the molecular layer containing nitrogen atoms, there can be listed nitrogen molecular layer and NH₃ molecular layer.

### Effect of the Invention

According to the present invention, there can be achieved an advantage in that the adhesiveness between the barrier metal film and the Cu film can be improved even in a low temperature anneal processing by forming the molecular layer containing nitrogen atoms as the interface layer between the barrier metal film and the Cu film.

### Best Mode for Carrying Out the Invention

According to an embodiment, a thick barrier metal film composed of Ti, Ta, and the like is formed, while supplying Ar gas, by a sputtering method according to a known process condition.

A barrier metal film (Ti film, Ta film, and the like) can be formed in a predetermined film thickness using a target composed of metal constituting the barrier metal film (Ti, Ta, and the like) according to the known process condition of flow of inert gas such as Ar gas and the like in an amount of 5 to 10sccm and of discharge voltage of 300 to 500V.

The CVD-Cu film can be formed according to the known process condition. The material of the CVD-Cu film is not particularly limited and, for example, Cu (hfac) (tmvs) may be exemplified. This process can be performed by using Cu(hfac)(tmcs) as a raw material under conditions of film forming pressure of 100 to 200Pa, and film forming temperature of 180 to 220°C.

The formation of Cu film on CVD-Cu film by the PVD method and the like can be performed according to the known process conditions. For example, the Cu film can be formed in a predetermined thickness on the CVD-Cu film by the PVD method under conditions of Ar flow amount of 5 to 10sccm, and the discharge voltage of 400 to 600V. In addition, the formation of Cu film by plating method and the like can also be performed by known process conditions.

According to another embodiment, the anneal processing may be performed only after the Cu film is formed by the PVD method, the plating method, the CVD method, or the ALD method.

According to an embodiment, after a nitrogen molecular layer or NH₃ molecular layer containing nitrogen atoms is formed on a barrier metal film by causing the barrier metal film to absorb, e.g., N₂ gas or NH₃ gas on the surface of the barrier metal film, and a CVD-Cu film is formed on the molecular layer containing nitrogen atoms as described above, the anneal processing may be performed at the above temperature, or a Cu film may be further formed on the CVD-Cu film as described above by the PVD method, the plating method, CVD method, or the ALD method after the anneal processing is performed and then the anneal processing may be performed again at the above temperature.

According to a further embodiment, after a nitrogen molecular layer or NH₃ molecular layer containing nitrogen atoms is formed on a barrier metal film by causing the barrier metal film to absorb, e.g., N₂ gas or NH₃ gas as described above and a nitrogen molecular layer or NH₃ molecular layer containing nitrogen atoms is formed and CVD-Cu film is formed on the nitrogen molecular layer as described above, a Cu film may be further formed on the Cu film as described above by the PVD method, the plating method, CVD method, or the ALD method and then the anneal processing may be performed at the above temperature.

As described above, by using gas containing nitrogen atoms such as N₂ gas or NH₃ gas, the gas molecules having only low energy are weakly combined with electrons owned by active metal such as Ti and the like while maintaining the characteristics of their own to a certain degree. Therefore, it is presumed that the surface of Ti metal and the like has absorbed therein the molecule layer containing nitrogen atoms such as nitrogen molecular layer, ammonia molecule layer, or their radical layer.

In case the radical layer is formed, radicals may be generated outside in advance, and the generated radicals may be transported to a chamber which is for forming molecule layer which contains nitrogen atoms. The apparatus and method of generating the radicals are not particularly limited; anything will do as long as the radicals can be generated from gas containing the nitrogen atoms. For example, there may be used radicals which are generated by supplying gas containing nitrogen atoms, to a catalyst containing vessel which is disclosed in Japanese Patent Application Laid-Open Publication No. 2005-298851. By using this catalyst containing vessel, the gas containing nitrogen atoms may be brought into contact with the heated catalysts for the purpose of activation, thereby generating the desired radicals. This catalyst containing vessel is so constructed that the shape of the internal space becomes gradually smaller toward the outlet of the activated gas, e.g., in the shape of a truncated conical shape or helical shape.

Metals, which are ordinarily employed as barrier metal, are active metals such as Ti, Ta, and W which are very reactive with impurities such as oxygen, fluorine compounds, water, ammonia, and the like as described above. Accordingly, an interface layer (for example, titanium oxide and the like, refer to reference examples described below) derived from these impurities is formed on the interface between the film composed of the barrier metal and the CVD-Cu film, whereby the adhesiveness between the barrier metal film and the Cu film is affected by the interface layer. The adhesiveness between the barrier metal film and the Cu film can be improved by controlling the formation of the interface layer. That is, the adhesiveness between the barrier metal film and the CVD-Cu film can be improved by the anneal processing performed at a relatively low temperature (in general, 100 to 400°C and preferably 200 to 350°C) by forming a molecule layer containing nitrogen atoms by causing the surface of the barrier metal to chemically absorb nitrogen gas and the like on the surface thereof.

When the barrier metal film of Ti, Ta, and the like is formed by the sputtering method (the PVD method) according to the known conditions and then the CVD-Cu film is formed according to the known conditions, the adhesiveness between the barrier metal film and the Cu film is not necessarily good, if any of processings is not performed. It is considered that this is because the surface of the barrier metal film is deteriorated with a result that the adhesiveness between the barrier metal film and the CVD-Cu film is degraded in any one or all of the period until the wafer is transported to a CVD chamber after the barrier metal film is formed on the wafer in a sputtering chamber, the period until the Cu film starts to be formed in the CVD chamber, and the initial stage at which the formation of the Cu film starts.

As described in the following examples, the degradation of film characteristics can be improved from a bad adhesiveness state to a good adhesiveness state by appropriately controlling the barrier metal/Cu interface and performing an appropriate heat treatment.

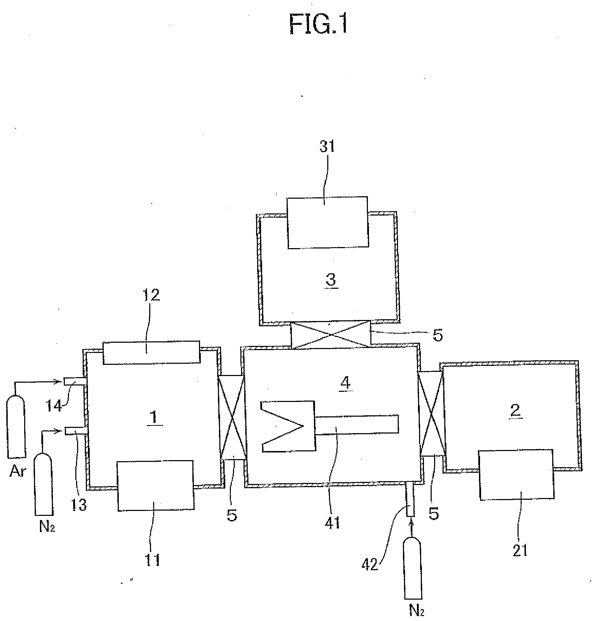

A film forming apparatus which can be used to embody the method of the present invention is not particularly limited, and a processing apparatus, e.g., as shown in Fig. 1 can be exemplified. The processing apparatus is composed of a sputtering chamber 1 for forming a barrier metal film on a substrate, which is transported from a chamber for storing substrates (not shown), by sputtering, a CVD film forming chamber 2 for forming a CVD-Cu film, an annealing chamber 3 having a resistance heating means, a lamp heating means, and the like, and a transportation chamber 4 on which a vacuum robot is mounted to transport a processed substrate. The sputtering chamber 1, the CVD film forming chamber 2, and the annealing chamber 3 are connected to each other around the transportation chamber 4 through a gate valve 5, and each of them has an evacuation means (not shown).

A substrate stage 11, on which the substrate is placed, is disposed in the sputtering chamber 1, a target 12, which is composed of the same metal as the barrier metal, is disposed in the sputtering chamber 11 opposite to the stage, an N₂ gas introduction path 13 and an Ar gas introduction path 14 are connected to a wall surface of the sputtering chamber. With this arrangement, the barrier metal film, and the molecular layer containing nitrogen atoms can be formed by introducing Ar gas and/or N₂ gas into the sputtering chamber. A substrate stage 21, on which the substrate is placed, is disposed in the CVD film forming chamber 2, the substrate to be processed is placed on the substrate stage 21, and the CVD-Cu film can be formed on the molecular layer containing nitrogen molecules. A substrate stage 31, which has the heating means as described above, is disposed in the annealing chamber 3. A robot 41 and an N₂ gas introduction path 42 are disposed in the transportation chamber 4. Note that when the PVD-Cu film is formed after the CVD-Cu film is formed, the PVD-Cu film is formed using a known PVD apparatus although it is not shown. In the following examples, processes were preformed using the film forming apparatus shown in Fig. 1.

When a Cu film is formed using the apparatus shown in Fig. 1, for example, first, a substrate to be processed is placed on the substrate stage 11 in the sputtering chamber 1, the inside of the chamber is evacuated, Ar gas is introduced into the sputtering chamber through the Ar gas introduction path 14, and a barrier metal film having a predetermined thickness is formed on the substrate stage. Next, the Ar gas is introduced into the sputtering chamber, N₂ gas is introduced thereinto through the N₂ gas introduction path 13, and a metal nitride film having a predetermined thickness is formed on the barrier metal film. Next, the substrate, on which the metal nitride film is formed, is transported into the CVD film forming chamber 2 by the robot 41 in the transportation chamber 4 and is placed on the substrate stage 21. After a CVD-Cu film having a predetermined thickness is formed on the substrate, the substrate is transported into the annealing chamber 3 by the robot 41, placed on the substrate stage 31, and then annealed by being heated to a predetermined temperature. Thereafter, a Cu film having a predetermined thickness is formed by the PVD method, plating method, CVD method, or ALD method, and subjected to the anneal processing when desired, thereby completing the process steps.

In the following examples, all processes including the deposition of a metal nitride interface layer in place of a nitrogen molecular layer do not form part of the present invention.

### (Reference Example 1)

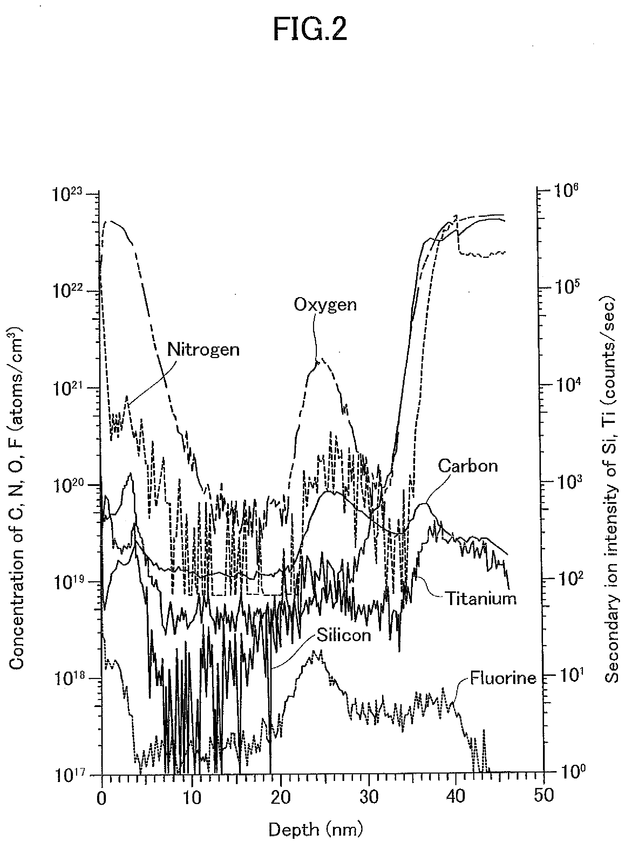

In a reference example, study was made on what type of composition of film was formed on the surface a PVD-Ti film. After a Ti film having a thickness of 15nm was formed on a wafer by the sputtering method using a Ti target, the Ti film was left in a vacuum chamber for one minute as it was, and the surface of the Ti film was subjected to an SIMS (secondary ion mass spectrometry) analysis. Fig. 2 shows a result of analysis. As is apparent from Fig. 2, it can be found that a film containing O, N, F and C was formed on the surface of the Ti film, the concentration of F, C was about 1% and thus the main component of the film was O, N. Accordingly, it can be found that oxidation of the Ti surface proceeded also in the vacuum chamber.

### Example 1

By using a silicon wafer with thermal oxide film as a wafer, a Ti film as a barrier metal was formed to a thickness of 15nm on the wafer by the magnetron sputtering method which uses a Ti target under conditions of Ar gas flow of 8 sccm and discharge voltage of 400V at room temperature. Thereafter, Ar gas of 8sccm and N₂ gas of 40sccm were introduced onto the PVD-Ti film under conditions of substrate voltage of 100V and cathode power of 5kW, thereby forming a TiN film. Subsequently, on top of this TiN film there was formed a Cu film to a thickness of 100nm by the CVD method using Cu (hfac) (tmvs) as a raw material under conditions of film-forming pressure of 150Pa and film-forming temperature of 200°C. Thereafter, on top of this CVD-Cu film there was formed by the PVD method a Cu film (PVD-Cu film) to a thickness of 1000nm under conditions of Ar flow amount of 8 sccm and discharge voltage of 500V. Annealing process was subsequently performed at 350°C.

An adhesiveness test of the barrier metal film and the CVD-Cu film was performed to the thus obtained wafer by a so-called tape test. In the tape test, square shapes were drawn with a diamond pen and the like at arbitrary locations in the central portion and the peripheral portion on the surface of the PVD-Cu film, and after adhesive tapes were adhered onto the locations scratched with the diamond pen and then peeled, and adhesiveness was evaluated by the amounts of the Cu film adhered onto the tape.

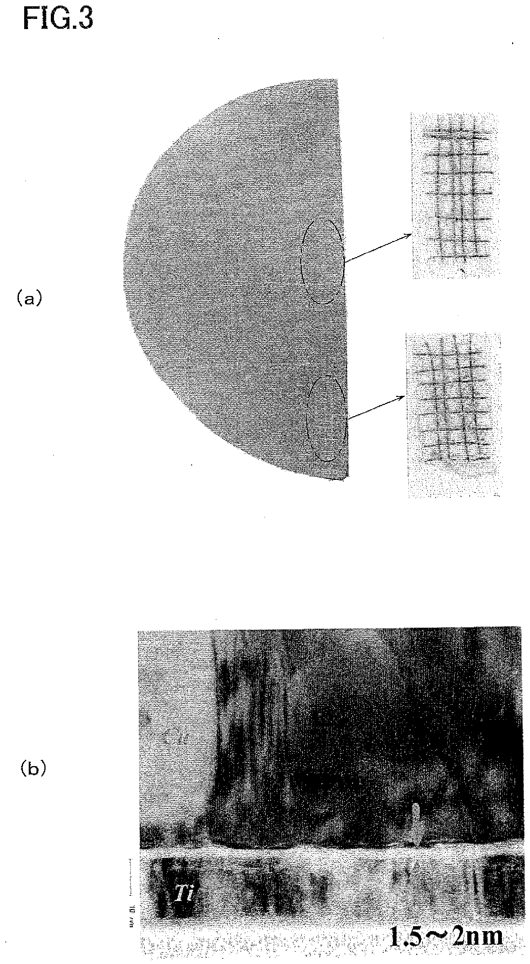

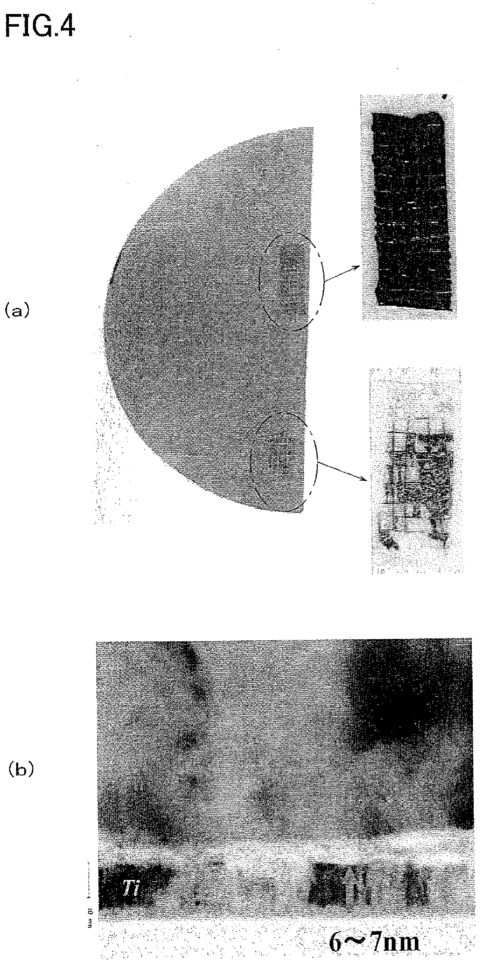

Apart (a) of Fig. 3 shows a result of the adhesiveness test, and a part (a) of Fig. 4 shows a TEM photograph of the cross section of the thus obtained wafer. The part (a) of Fig. 3 is a plan view of the wafer after the test and shows the central portion and the peripheral portion of the wafer on the sides thereof to which the adhesive layer of the peeled tape is adhered in enlargement.

Further, for comparison, the above processes were repeated except that no TiN film was formed, and the same adhesiveness test was performed to a resultant wafer. A part (a) of Fig. 4 shows a result of the adhesiveness test, and a part (b) of Fig. 4 shows a TEM photograph of the cross section of the thus obtained wafer. A part (a) of Fig. 4 is a plan view of the wafer after the test and shows in enlargement the central portion and the peripheral portion of the wafer on the sides thereof to which the adhesive layer of the peeled tape is adhered.

As is apparent from the parts (a) and (b) of Fig. 3, it can be found that when the TiN film is disposed between the PVD-Ti film and the CVD-Cu film, no film is peeled in the interface between the Ti film and the Cu film also in the central portion and the peripheral portion of the wafer and the adhesiveness is improved as compared with the case that the TiN film shown in the parts (a) and (b) of Fig. 4 is not formed. It is considered that this is because the adhesiveness depends on only the thickness of the interface layer (TiNx) and the thickness of the interface layer is about 6 to 7 nm in the part (b) of Fig. 4, although the thickness of the interface layer in the part (b) of Fig. 3 is about 1.5nm to 2nm.

### Example 2

By using a silicon wafer with thermal oxide film as a wafer, a PVD-Ti film, TiN film and nitrogen molecular film, as well as CVD-Cu film (film thickness: 10nm) were formed on the wafer as a barrier metal film under conditions shown in Table 1. Thereafter, the anneal processing was not performed or performed at 350 to 450°C for 3 minutes, and after a PVD-Cu film (film thickness: 1000nm) was formed, a Cu film was formed on the barrier metal film by not performing the anneal processing or performing it at 350 to 450°C for 10 minutes. In this manner, 16 types of specimens were made. The same tape test as the example 1 was performed to the 16 types of the specimens, and Table 1 shows processing conditions and a result of the tape test.

**(Tableau 1)**

| | PVD-Ti film | | CVD-Cu film | | Anneal processing | | PVD-Cu film | | Anneal processing | | Result of test | |
|---|---|---|---|---|---|---|---|---|---|---|---|---|
| Specimen No. | Film thickness (nm) | Temperature (°C) | Preliminary processing time (second) | Film thickness (nm) | Temperature (°C) | Time (minute) | Film thickness (nm) | Temperature (°C) | Temperature (°C) | Time (minute) | Central portion | Peripheral portion |
| 1 | 15 | Room temperature | 25 | 100 | - | - | 1000 | | - | - | NG | NG |
| 2 | " | " | " | " | - | - | " | | 350 | 10 | NG | NG |
| 3 | " | " | " | " | - | - | " | | 400 | " | Δ | Δ |
| 4 | " | " | " | " | - | - | " | | 450 | " | OK | OK |
| 5 | " | " | " | " | 350 | 3 | " | | - | - | NG | NG |
| 6 | " | " | " | " | 400 | " | " | | - | - | NG | NG |
| 7 | " | " | " | " | 450 | " | " | | - | - | OK | OK |
| 8 | "(TiNx 1nm) | " | " | " | 350 | " | " | | 350 | " | OK | Δ |
| 9 | " (+N₂introbuction) | " | " | " | " | " | " | | " | " | OK | OK |

In Table 1 that shows the result of the test, NG shows that the film is peeled, Δ shows that almost no problem occurs in practical use although a peeled film is somewhat observed, and OK shows that no peeled film is observed.

As is apparent from the result of Table 1, it is observed that the adhesiveness is bad and peeling is observed in the interface layer in the specimen (specimen No. 1), in which the anneal processing was not performed to the CVD-Cu film and PVD-Cu film after they were formed as wiring films, in the specimen (specimen No. 2), in which although the anneal processing was not performed after the CVD-Cu film was formed, the anneal processing was performed at 350°C after PVD-Cu film was formed, and in specimens (specimens Nos. 5 and 7) in which although the anneal processing was performed at 350°C or 400°C after the CVD-Cu film was formed, the anneal processing was not performed after the PVD-Cu film was formed.

The adhesiveness is good and no peeling is observed in the interface layer: in specimens (specimens Nos. 3, 4) in which, although the anneal processing was not performed after the CVD-Cu was formed, the anneal processing was performed at 400°C or 450°C after the CVD-Cu film was formed; in a specimen (specimen No. 9) in which, although the anneal processing was performed at 450°C after the CVD-Cu film was formed, the anneal processing was not performed after the PVD-Cu was formed; and in specimens (specimens Nos. 6, 8 and 10 - 16) in which the anneal processing was performed at 350°C or 400°C or 450°C after the CVD-Cu film was formed as well as the anneal processing was performed at 350°C, 400°C or 450 °C also after the PVD-Cu film was formed. In the specimen Nos. 13 and 15, after a PVD-Ti film was formed to a thickness of 15nm by the magnetron sputtering method which uses Ti target and introduces Ar gas, a TiNx film was formed to a thickness of 1 nm by the magnetron sputtering method which uses the Ti target by introducing and discharging Ar gas and N₂ gas, and then the processing was performed as described in Table 1. Further, in the specimen Nos. 14 and 16, after forming a PVD-Ti film to a thickness of 15 nm, which is obtained by introducing Ar gas using a Ti target, a nitrogen molecular layer was formed on the PVD-Ti film by introducing N₂ gas without discharging, and then the processing was performed as described in Table 1.

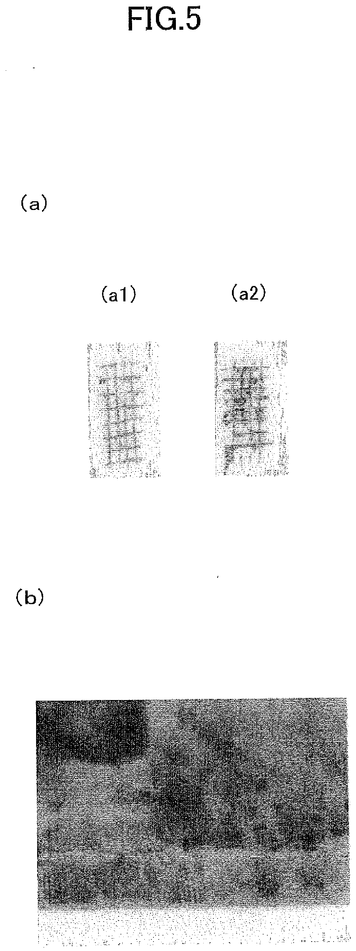

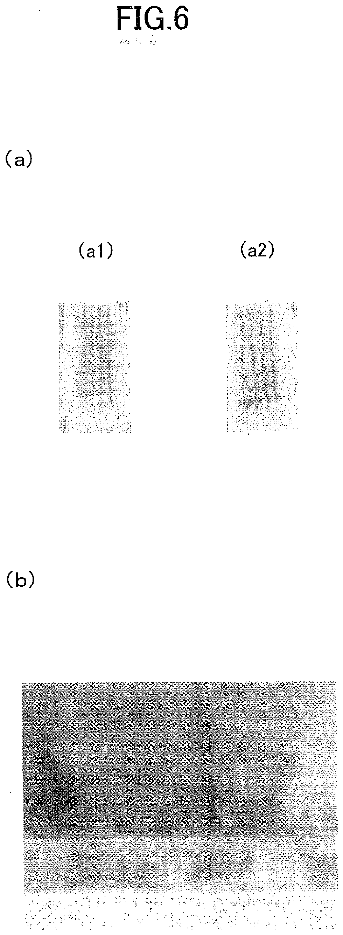

Part (a) of Fig. 5 and part (a) of Fig. 6 show the results of tests performed in the same manner as in example 1 on obtained wafers in specimen Nos. 13 and 14. In addition, Part (b) of Fig. 5 and part (b) of Fig. 6 show TEM photographs of cross sections of the obtained wafers. Part (a) of Fig. 5 and part (a) of Fig. 6 show plan views of wafers after testing and show the central part (Fig. 5a(a1) and Fig. 6a(a1)) and peripheral part (Fig. 5b (b1) and Fig. 6b (b1)) where an adhesive layer of the peeled tape is attached.

As is apparent from the result, it can be found that since the PVD-Ti film was formed and then the TiNx film or a nitrogen molecular layer was formed on the Ti film, even if they were annealed at a low temperature, no film was peeled in the interface between the Ti film and the Cu film and that a Cu wiring film having good adhesiveness could be formed. An anneal temperature is preferably a temperature as low as possible at which an initial object can be achieved in consideration of the stress migration of Cu. Accordingly, like specimen Nos. 13 and 14, it is ordinarily preferable to perform the anneal processing at 400°C and preferably at 350°C or less.

Note that, in the specimens shown in Table 1, the thickness of the interface layer between the barrier metal film and the CVD-Cu film was about 1.5nm to 2nm when the TiNx film and the nitrogen molecular layer were formed in the same manner as in the example 1, and about 6 to 7nm when the TiNx film or the nitrogen molecular layer was not formed.

### Example 3

In an example 3, when a CVD-Cu was formed on a barrier metal film, the structure of the interface between these films was examined.

A specimen was made by using a silicon wafer with thermal oxide film as a wafer, forming a Ti film as a barrier metal to a thickness of 15nm on the wafer by the magnetron sputtering method under conditions of Ar gas flow of 8sccm and discharge voltage of 400V, forming a TiNx film on the Ti film to a thickness of 0.5nm under conditions of Ar gas flow of 8sccm and discharge voltage of 400V, forming a Cu film on the TiNx film to a thickness of 100nm under conditions of 200°C, and thereafter performing the anneal processing at 350°C. For comparison, a specimen, on which no TiNx film was formed, was made by directly forming the CVD-Cu film on the PVD-Ti film and then performing the anneal processing at 350°C.

The adhesiveness between the PVD-Ti film and the CVD-Cu film of each of the thus obtained specimens was examined as well as the TEM photographs of the cross sections of these specimens were examined by subjecting the specimens to the same tape test as the example 1. The result of the examination is the same as that shown in the parts (a) and (b) of Fig. 3 and the parts (a) and (b) of Fig. 4. That is, it can be found that when the TiNx film was formed between the PVD-Ti film and the CVD-Cu film, no film was peeled on the interface between the Ti film and the Cu film in the central portion and the peripheral portion of the wafer and the adhesiveness was improved as compared with the case in which no TiNx film was formed. Further, when the TiNx was formed, the thickness of the interface layer was about 1.5 to 2nm likewise the example 1, and when the TiNx was not formed, the thickness of the interface layer was about 6 to 7 nm.

It is considered that the interface layer between the PVD-Ti film and the CVD-Cu film is ordinarily formed because the surface of the Ti film is oxidized in any of the period until the wafer was transported to the CVD chamber after the Ti film is formed on the wafer, the period until the CVD-Cu film starts to be formed in the CVD chamber, and the initial stage of formation of the CVD-Cu film in the CVD chamber. In this case, it is considered that the adhesiveness can be improved because the formation of the oxide layer (interface layer) is suppressed by forming the TiNx film and the nitrogen molecular layer on the Ti film and both Ti and Cu can be mutually diffused easily in the anneal processing due to the very thin thickness of the interface layer.

### [Industrial Applicability]

According to the present invention, since the adhesiveness between the barrier metal film and the Cu film can be improved by forming the thin molecular layer containing nitrogen atoms as the interface layer between the barrier metal film and the Cu film, the preset invention is a useful art that can be utilized when a wiring film is formed in the field of a semiconductor technology.

### Brief Description of the Drawings

Fig. 1 is a schematic arrangement view of a film forming apparatus for embodying a method of forming a Cu film of the present invention.
Fig. 2 is an SIMS analysis spectrum view of the surface a Ti film in a reference example 1.

Parts (a) and (b) of Fig. 3 are photographs showing the adhesiveness and the cross sectional structure of a specimen obtained in an example 1, wherein the part (a) is a plan view of a wafer which shows the result of a tape test showing the adhesiveness of the specimen and shows a central portion and a peripheral portion of the wafer on the sides thereof where the adhesive layer of the peeled tape is attached in enlargement, and the part (b) is a TEM photograph showing a cross section of the wafer.

Parts (a) and (b) of Fig. 4 are photographs showing the adhesiveness and the cross sectional structure of a corresponding specimen obtained in the example 1, wherein the part (a) is a plan view of a wafer which shows the result of a tape test showing the adhesiveness of the specimen and shows a central portion and a peripheral portion of the wafer on the sides thereof where an adhesive layer of the peeled tape is attached in enlargement, and the part (b) is a TEM photograph showing a cross section of the wafer.

Parts (a) and (b) of Fig. 5 are photographs showing the adhesiveness and the cross sectional structure of a specimen No. 13 obtained in the example 2, wherein the part (a) is a plan view of a wafer which shows the result of a tape test showing the adhesiveness of the specimen and shows a central portion (a1) and a peripheral portion (a2) of the wafer on the sides thereof where an adhesive layer of the peeled tape is attached, and the part (b) is a TEM photograph showing a cross section of the wafer.

Parts (a) and (b) of Fig. 6 are photographs showing the adhesiveness and the cross sectional structure of a specimen No. 14 obtained in the example 2, wherein the part (a) is a plan view of a wafer which shows the result of a tape test showing the adhesiveness of the specimen and shows a central portion (a1) and a peripheral portion (a2) of the wafer on the sides thereof where an adhesive layer of the peeled tape is attached, and the part (b) is a TEM photograph showing a cross section of the wafer.

### Explanation of Reference Numerals

- 1: sputtering chamber
- 2: CVD film forming chamber
- 3: annealing chamber
- 4: transportation chamber
- 5: gate valve
- 11, 21, 31: substrate stage
- 12: target
- 13, 42: N₂ gas introduction path
- 14: Ar gas introduction path
- 41: robot

## Claims

1. A method of forming a Cu film by forming a Ti film or a Ta film as a barrier metal film by a sputtering method and forming the Cu film on the barrier metal film by a CVD method, wherein after a molecular layer containing nitrogen atoms is formed on the barrier metal film by causing the barrier metal layer to absorb gas containing nitrogen atoms on the surface thereof and the Cu film is formed on the molecular layer containing nitrogen atoms by the CVD method, an anneal processing is performed at 100 to 400°C to perform mutual diffusion between the barrier metal film and the Cu film.

2. The method of forming a Cu film according to claim 1, wherein after the anneal processing is performed, a Cu film is further formed on the Cu film by a PVD method or a plating method.

3. The method of forming a Cu film according to claim 2, wherein after the Cu film is formed by the PVD method or the plating method, the anneal processing is performed again at 100 to 400°C.

4. The method according for claim 1, wherein the Cu film is a first Cu film and a second Cu film is further formed on the first Cu film by a PVD method or a plating method, and then said anneal processing is performed at 100 to 400°C.

5. The method of forming a Cu film according to any of claims 1 to 4, wherein the barrier metal film is formed by supplying Ar gas.

6. The method of forming a Cu film according to any of claims 1 to 5, wherein the gas containing nitrogen atoms is N₂ gas or NH₃ gas and that the molecular layer containing nitrogen atoms is nitrogen molecular layer or NH₃ molecular layer.

## Patentansprüche

1. Verfahren zur Bildung eines Cu-Films durch Bilden eines Ti-Films oder eines Ta-Films als Sperrmetallfilm durch ein Sputter-Verfahren und Bilden des Cu-Films auf dem Sperrmetallfilm durch ein CVD-Verfahren, wobei nachdem eine Stickstoffatome-enthaltende Molekularschicht auf dem Sperrmetallfilm gebildet wird, indem die Sperrmetallschicht dazu gebracht wird, Stickstoffatome-enthaltendes Gas an ihrer Oberfläche zu absorbieren und der Cu-Film auf der Stickstoffatome-enthaltenden Molekularschicht durch das CVD-Verfahren gebildet wird, eine Glühbehandlung bei 100 bis 400 °C durchgeführt wird, um eine wechselseitige Diffusion zwischen dem Sperrmetallfilm und dem Cu-Film durchzuführen.

2. Verfahren zur Bildung eines Cu-Films gemäß Anspruch 1, wobei nachdem die Glühbehandlung durchgeführt ist, ferner ein Cu-Film auf dem Cu-Film durch ein PVD-Verfahren oder ein Plattierungsverfahren gebildet wird.

3. Verfahren zur Bildung eines Cu-Films nach Anspruch 2, wobei nachdem der Cu-Film durch das PVD-Verfahren oder das Plattierungsverfahren gebildet wird, erneut die Glühbehandlung bei 100 bis 400°C durchgeführt wird.

4. Verfahren nach Anspruch 1, wobei der Cu-Film ein erster Cu-Film ist und ein zweiter Cu-Film ferner durch ein CVD-Verfahren oder ein Plattierungsverfahren auf dem ersten Cu-Film gebildet wird, und dann diese Glühbehandlung bei 100 bis 400°C durchgeführt wird.

5. Verfahren zur Bildung eines Cu-Films nach einem der Ansprüche 1 bis 4, wobei der Sperrmetallfilm durch Zufuhr von Ar-Gas gebildet wird.

6. Verfahren zur Bildung eines Cu-Films nach einem der Ansprüche 1 bis 5, wobei das Stickstoffatome-enthaltende Gas N₂-Gas oder NH₃-Gas ist und dass die Stickstoffatome-enthaltende Molekularschicht eine Stickstoffmolekularschicht oder eine NH₃-Molekularschicht ist.

## Revendications

1. Procédé de formation d'un film Cu en formant un film Ti ou un film Ta comme film métallique barrière par un procédé de pulvérisation cathodique, et en formant le film Cu sur le film métallique barrière par un procédé de dépôt chimique en phase vapeur (CVD, Chemical Vapor Deposition), dans lequel après formation d'une couche moléculaire contenant des atomes d'azote sur le film métallique barrière en faisant en sorte que la couche métallique barrière absorbe le gaz contenant les atomes d'azote à la surface de celui-ci, et après formation du film Cu sur la couche moléculaire contenant des atomes d'azote par le procédé CVD, un traitement de recuit est réalisé à 100 à 400 °C pour réaliser une diffusion mutuelle entre le film métallique barrière et le film Cu.

2. Procédé de formation d'un film Cu selon la revendication 1, dans lequel après réalisation du traitement de recuit, un film de Cu est en outre formé sur le film Cu par un procédé de dépôt physique en phase vapeur (PVD, Physical Vapor Déposition) ou un procédé de revêtement métallique.

3. Procédé de formation d'un film Cu selon la revendication 2, dans lequel après formation du film Cu par le procédé PVD ou le procédé de revêtement métallique, un traitement de recuit est à nouveau réalisé à 100 à 400 °C.

4. Procédé de formation d'un film Cu selon la revendication 1, dans lequel le film Cu est un premier film Cu, et un second film Cu est en outre formé sur le premier film Cu par un procédé PVD ou un procédé de revêtement métallique, puis ledit traitement de recuit est réalisé à 100 à 400 °C.

5. Procédé de formation d'un film Cu selon l'une quelconque des revendications 1 à 4, dans lequel le film métallique barrière est formé par la fourniture de gaz Ar.

6. Procédé de formation d'un film Cu selon l'une quelconque des revendications 1 à 5, dans lequel le gaz contenant les atomes d'azote est un gaz N₂ ou un gaz NH₃, et la couche moléculaire contenant les atomes d'hydrogène est une couche moléculaire d'azote ou une couche moléculaire NH₃.
